# EUROPEAN PATENT APPLICATION

(11) **EP 4 156 313 A1**
(43) Date of publication of application: **29.03.2023**
(21) Application number: 22183014.4
(22) Date of filing: 05.07.2022
(51) Int. Cl.: H01L 49/02

(54) **MULTILAYER CAPACITOR WITH EDGE INSULATOR**

(30) Priority: 24.09.2021 US 202117484981
(71) Applicant: INTEL Corporation, Santa Clara, CA 95054 (US)
(72) Inventor: LIN, Chia-Ching, Portland, 97229 (US); CHANG, Sou-Chi, Portland, 97229 (US); Oguz, Kaan, Portland, 97229 (US); TUNG, I-Cheng, Hillsboro, 97124 (US); SEN GUPTA, Arnab, Hillsboro, 97124 (US); YOUNG, Ian, Olympia, 98512 (US); AVCI, Uygar E., Portland, 97225 (US); METZ, Mathew, Portland, 97229 (US)
(74) Representative: Goddar, Heinz J.

(57) **Abstract**

Embodiments described herein may be related to apparatuses, processes, and techniques related to stacked MIM capacitors with multiple metal and dielectric layers that include insulating spacers on edges of one or more of the multiple layers to prevent unintended electrical coupling between metal layers during manufacturing. The dielectric layers may include Perovskite-based materials. Other embodiments may be described and/or claimed.

## Description

### FIELD

Embodiments of the present disclosure generally relate to the field of semiconductor packaging, and in particular to capacitors within dies and packages.

### BACKGROUND

Continued growth in virtual machines, cloud computing, and portable devices will continue to increase the demand for high density capacitors within chips and packages.

### BRIEF DESCRIPTION OF THE DRAWINGS

FIGs. 1A-1B illustrate a schematic and a block diagram that shows metal-insulator-metal (MIM) capacitors within a die and a package.
FIG. 2 illustrates a block diagram of a cross-section of a two plate MIM capacitor using Perovskite-based high-k materials, in accordance with various embodiments.
FIG. 3 illustrates a cross section side view of a stacked MIM capacitor, in accordance with various embodiments.
FIGs. 4A-4F show various stages in a legacy manufacturing process that uses a polish for creating a MIM structure.
FIGs. 5A-5D shows various stages in a manufacturing process for creating edge insulators for layers within a multilayer MIM structure, in accordance with various embodiments.
FIG. 6 illustrates a multilayer MIM structure that includes edge insulators, in accordance with various embodiments.
FIG. 7 illustrates an example of a multi-plate MIM structure, in accordance with various embodiments.
FIG. 8 illustrates an example process for manufacturing a multilayer MIM structure that includes edge insulators, in accordance with various embodiments.
FIG. 9 illustrates a computing device 900 in accordance with one implementation of the invention.
FIG. 10 illustrates an interposer 1000 that includes one or more embodiments of the invention.

### DETAILED DESCRIPTION

Embodiments described herein may be related to apparatuses, processes, and techniques directed to a MIM capacitor with multiple layers that include insulators on edges of one or more of the multiple layers. Embodiments may include a first electrode layer with a first side and a second side opposite the first side, the first side of the first electrode layer coupled with the substrate. Embodiments may further include a Perovskite layer with a first side and a second side opposite the first side, the first side of the Perovskite layer physically coupled with the second side of the first electrode layer. Embodiments may further include an insulator directly physically coupled with an edge of the electrode layer between the first side of the first electrode layer and the second side of the electrode layer, and directly physically coupled with an edge of the Perovskite layer between the first side of the Perovskite layer and the second side of the Perovskite layer, wherein the insulator extends from the second side of the Perovskite layer to the first side of the first electrode layer. Embodiments may further include a second electrode layer directly physically coupled with the second side of the Perovskite layer, the second electrode layer electrically isolated from the first electrode layer by the edge insulator.

In embodiments, MIM capacitors that include a Perovskite-based materials for a dielectric layer within the MIM capacitor may be used to achieve a dielectric constant for the MIM capacitor in excess of 150. Legacy manufacturing processes for MIM capacitors that do not use Perovskite-based materials include planarization and polish processes may result in a higher defect rate in the resulting MIM structures. In particular, defects may result in these legacy processes when additional metal layers are applied that may electrically short with previously applied metal layers due to portions of insulator layers being polished away. This may be due to the MIM structure being very thin and wide.

In embodiments, manufacturing processes for MIM structures may involve applying an oxide over a Perovskite dielectric layer that is coupled with a metal layer below, and etching the applied oxide to expose a surface of the Perovskite dielectric layer. This process will leave additional oxide to serve as an electrical insulator on the edges of the Perovskite dielectric layer and the metal layer below, which will prevent additional metal layers applied during the manufacturing process coming into electrical contact with the metal layer below. This additional oxide on the edges of the layers may be referred to as a oxide spacer, or a spacer.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

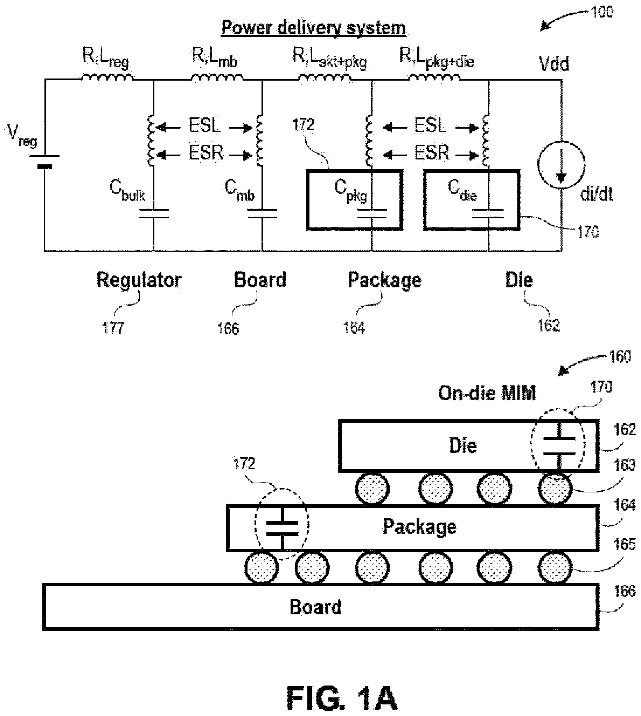

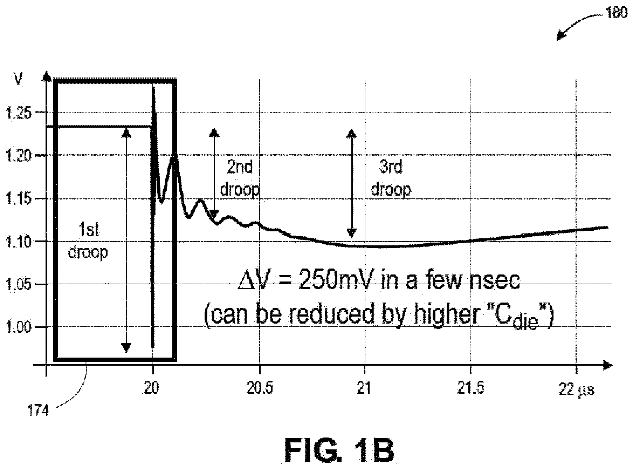

FIGs. 1A-1B illustrate a schematic and a block diagram that shows metal-insulator-metal (MIM) capacitors within a die and a package. FIG. 1A illustrates a block diagram that shows MIM capacitors from regulator to die. FIG. 1B illustrates a schematic that shows MIM capacitors within a die and a package. With respect to FIG. 1A, diagram 100 is a schematic that shows a portion of various circuitry associated with the components of the system 160. In particular, die 162 may be electrically coupled with package 164 using interconnect 163. The package 164 may be electrically coupled with a printed circuit board (PCB) 166 using interconnect 165. In embodiments, PCB 166 may be a motherboard. Note that a voltage regulator 177 (not shown in FIG. 1B) may be used to provide power to the die 162, the package 164, and/or the PCB 166.

A capacitor 170, which in embodiments may be a MIM capacitor, may be included on the die 162. In other embodiments, another capacitor 172, which in embodiments may be a MIM capacitor, may also be included on the package 164. In embodiments, the capacitors 170, 172 may be multiple capacitors that provide a higher capacitance density that may minimize a first droop during load switching, as shown with respect to highlighted area 174 of graph 180. With respect to FIG. 1B, graph 180 shows a relationship between voltage and time (in microseconds), with respect to various voltage droops. For example, if there is no on die MIM, the power from the regulator to microprocessor will be delayed, which may result in a first voltage drop as large as 250 mV, degrading microprocessor performance. There is an advantage to an on die MIM two-story charge near transistors in order to supply a charge to the die faster.

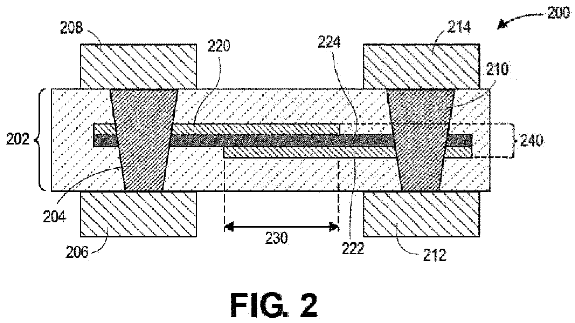

FIG. 2 illustrates a block diagram of a cross-section of a two plate MIM capacitor using Perovskite-based high-k materials, in accordance with various embodiments. MIM 200 includes a first metal layer 220 and a second metal layer 222 that are separated by dielectric 224. In embodiments, dielectric 224 may be a Perovskite-based high-k dielectric. The first metal layer 220, the layers of dielectric 224, and the second metal layer 222 may be referred to as a MIM stack.

The first metal layer 220 may be electrically coupled with a first electrical contact 204 which may be electrically and/or physically coupled with pads 206, 208 on either side of a core 202. Similarly, the second metal layer 222 may be electrically coupled with a second electrical contact 210 which may be electrically and/or physically coupled with pads 212, 214 on either side of the core 202. As shown, an area of overlap 230 where the first metal layer 220 and the second metal layer 222 overlap, may be referred to as an active portion of the MIM stack 240. In embodiments, the area of overlap 230 may form an area of at least 50 µm x 50 µm. In embodiments, the pads 206, 208, 312, 314 may be on two different metal layers on the top of a die, for example that may be within (not shown) die 162 of FIG. 1A.

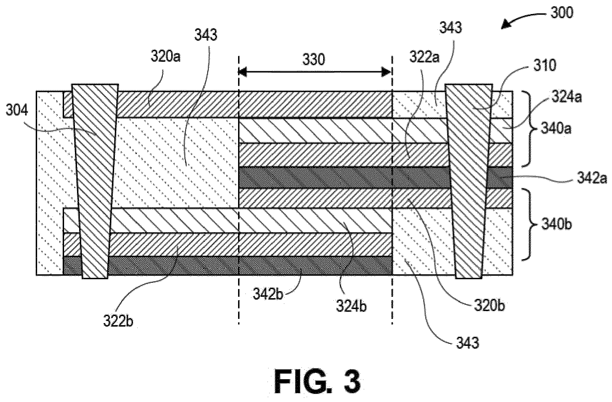

FIG. 3 illustrates a cross section side view of a stacked MIM capacitor, in accordance with various embodiments. Diagram 300 shows a cross-section of two MIMs 340a, 340b stacked on top of each other in a layered configuration. A first electrical contact 304, and a second electrical contact 310, which may be similar to first electrical contact 204 and second electrical contact 210 of FIG. 2, are shown.

The first electrical contact 304 may be electrically coupled with the first metal layer 320a of MIM 340a, and may also be electrically coupled with the second metal layer 322b of MIM 340b. The second electrical contact 310 may be electrically coupled with the second metal layer 322a of MIM 340a, and may also be electrically coupled with the first metal layer 320b of MIM 340b. Below the second metal layer 322b there may be a seeding layer 342b that may be used to grow, or otherwise to build up the second metal layer 322b. Similarly, below the second metal layer 322a, there may be a seeding layer 342a that may be used to grow, or otherwise to build up the second metal layer 322a.

Dielectric 324a is placed between the first metal layer 320a and second metal layer 322a, and dielectric 324b is placed between the first metal layer 320b and second metal layer 322b. The dielectric layers 324a, 324b may be a Perovskite-based high-k dielectric. Note that the area overlap 330, which may be similar to the area of overlap 230 of FIG. 2, indicates an active portion of the capacitor structure shown in diagram 300. Areas 343 may include an insulator material or some other nonconductive material, which may include an oxide or a nitride material.

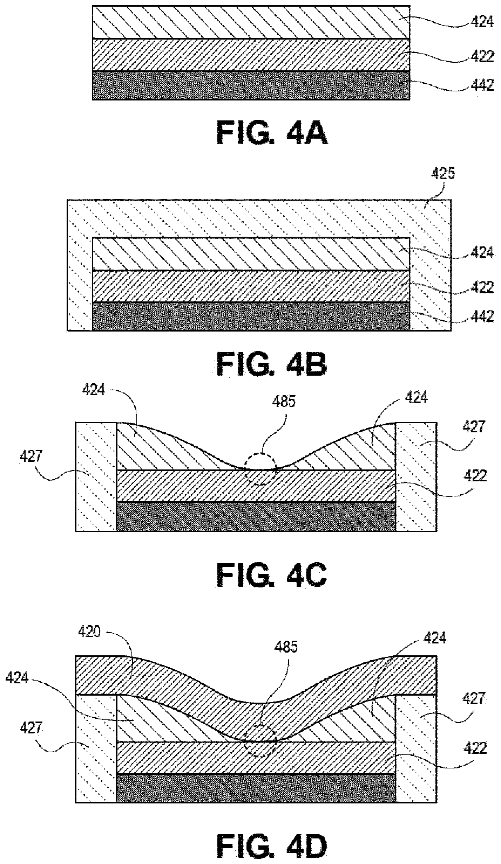

FIGs. 4A-4F show various stages in a legacy manufacturing process that uses a polish for creating a MIM structure. FIG. 4A shows a stage in the legacy manufacturing process where a seeding layer 442, which may be similar to seeding layer 342b of FIG. 3, is formed. In embodiments, the seeding layer 442 may include copper, aluminum, tantalum, titanium, and/or nitrogen, and may be formed on a substrate (not shown). A metal layer 422, which may be similar to metal layer 322b of FIG. 3, is formed on top of the seeding layer 442. In embodiments, the metal layer 422 may be grown on the seeding layer 442. A dielectric layer 424, which may be similar to dielectric layer 324b and which may include Perovskite-based material, is formed on the metal layer 422. In embodiments, the dielectric layer 424 may be formed using physical vapor deposition (PVD) techniques.

FIG. 4B shows a stage in the legacy manufacturing process where a passivation layer 425 may be formed around the seeding layer 442, the metal layer 422, and the dielectric layer 424. In embodiments, the passivation layer 425 may be deposited using chemical vapor deposition (CVD) techniques, and may include silicon, nitrogen, oxygen, aluminum, hafnium, titanium, and/or zirconium. For example, SiN, SiO, Al2O3, HfOx, TiO2, HfZrOx.

FIG. 4C shows a stage in the legacy manufacturing process where a portion of the passivation layer 425 is removed using a polish process, leaving a remaining passivation layer 427. Although the polish process removes the passivation layer 425 at the top surface of the dielectric layer 424, the polish process also exposes area 485 of the metal layer 422. This may be referred to as over-polishing.

FIG. 4D shows a stage in the legacy manufacturing process where a second metal layer 420 is deposited over the dielectric layer 424, and over a portion of the remaining passivation layer 427. Because of the over-polishing described with respect to FIG. 4C, the second metal layer 420 will come into electrical contact with the metal layer 422 at area 485. The result of this electrical contact will be an electrical short between metal layer 422 and second metal layer 420.

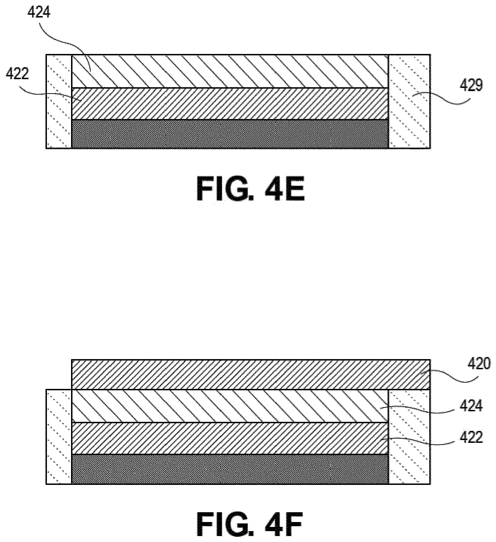

FIG. 4E shows a desired stage in the legacy manufacturing process after the stage of FIG. 4B, if the polish process did not remove excess passivation layer 425 and instead left passivation layer 429 that completely surrounds the edges of the metal layer 422.

FIG. 4F shows a desired stage in the legacy manufacturing process after the desired stage FIG. 4E, where a second metal layer 420 is deposited on the dielectric layer 424 and does not come into electrical contact with metal layer 422. It should be noted that the desired legacy manufacturing process stages shown in FIGs. 4D-4E are desired but are not consistently achievable due to the thinness of the dielectric layer of 424, in particular when the dielectric includes a Perovskite layer that is thin, for example between 4 nm and 40 nm.

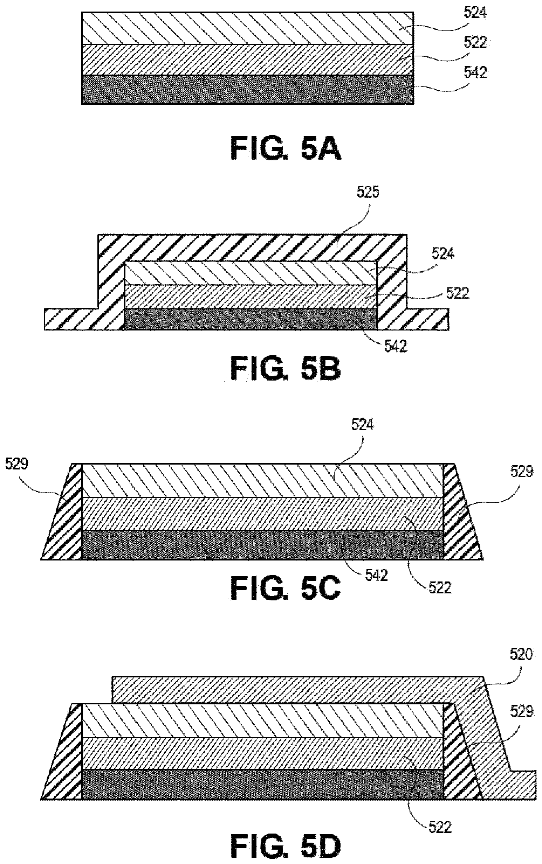

FIGs. 5A-5D shows various stages in a manufacturing process for creating edge insulators for layers within a multilayer MIM structure, in accordance with various embodiments. FIG. 5A shows a stage in the manufacturing process where a seeding layer 542, which may be similar to seeding layer 342b of FIG. 3, is formed. In embodiments, the seeding layer 542 may include copper, and may be formed on a substrate (not shown). A metal layer 522, which may be similar to metal layer 322b of FIG. 3, is formed on top of the seeding layer 542. In embodiments, the metal layer 522 may be grown on the seeding layer 542. A dielectric layer 524, which may be similar to dielectric layer 324b and which may include Perovskite-based material, is formed on the metal layer 522. In embodiments, the dielectric layer 524 may be formed using physical vapor deposition (PVD) techniques.

FIG. 5B shows a stage in the manufacturing process where an insulative material 525 is applied and covers the dielectric layer 524, the metal layer 522, and the seeding layer 542. In embodiments, an atomic layer deposition (ALD) process may be used to deposit a layer of insulating material 525. In embodiments, the insulating material 525 may include silicon nitride, silicon oxide, or some other similar insulative material. Examples include: SiN, SiO, Al2O3, HfOx, TiO2, and/or HfZrOx. In some embodiments, a layer of insulating material 525 may only partially cover the dielectric layer 524, the metal layer 522, and the seeding layer 542.

FIG. 5C shows a stage in the manufacturing process where a chemical dry etch process is performed to remove a portion of the layer of insulating material 525, with spacers 529 that remain of the layer of insulating material 525. In embodiments, the spacers 529 may provide an electric insulation around the metal layer 522. As shown, the spacers 529 extend from a top of the dielectric layer 524 to the seeding layer 542. In embodiments, the spacers 529 may extend from a portion of the dielectric layer 524. Although the spacers 529 as shown are have a triangular cross-section shape, any shape may be used provided the spacers 529 provide an electric insulation around the metal layer 522 and the seeding layer 542.

FIG. 5D shows stage in the manufacturing process where a second metal layer 520, which may be similar to first metal layer 320b of FIG. 3, may be applied. In embodiments, the spacer 529 electrically separates the second metal layer 520 from the first metal layer 522 and 542.

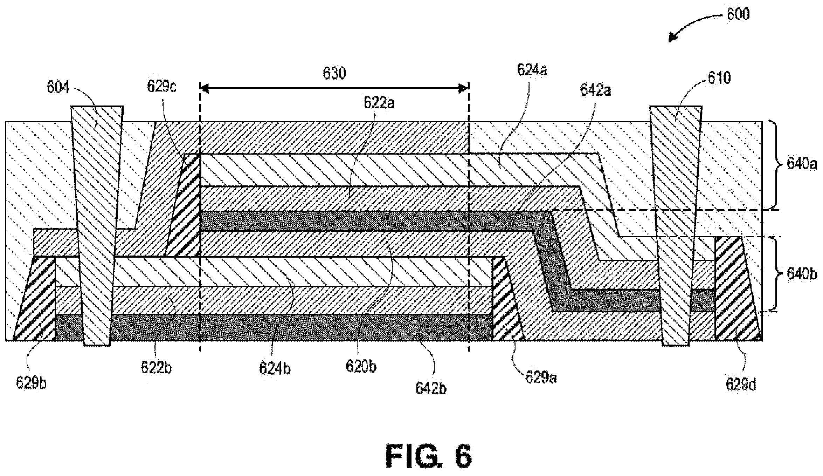

FIG. 6 illustrates a cross-section side view of a multilayer MIM structure, which may also be referred to as a stacked MIM structure, that includes edge insulators, in accordance with various embodiments. The stacked MIM structure 600 may be manufactured using the processes and stages described above with respect to FIGs. 5A-5D. In embodiments, stacked MIM structure 600 includes a first MIM structure 640a and a second MIM structure 640b, that may be similar to MIMs 340a, 340b of FIG. 3.

The second MIM structure 640b includes a seeding layer 642b, a first metal layer 622b on top of the seeding layer 642b, a dielectric layer 624b on top of the first metal layer 622b, and a second metal layer 620b on top of the dielectric layer 624b. A first spacer 629a, which may be similar to spacer 529 of FIG. 5D and may be manufactured using manufacturing stages similar to those described with respect to FIGs. 5A-5D, is placed at an end of the seeding layer 642b, first metal layer 622b, and dielectric layer 624b. Therefore, during manufacture, when the second metal layer 620b is applied it does not electrically couple with the first metal layer 622b. Note that at the time the first spacer 629a is manufactured, a second spacer 629b may also be concurrently manufactured.

The first MIM structure 640a includes a seeding layer 642a, onto which a first metal layer 622a is deposited. A dielectric layer 624a may subsequently be deposited on top of the first metal layer 622a. A third spacer 629c, which may be similar to first spacer 629a, may be placed on a top surface of the dielectric layer 624b. In embodiments, spacer 629c may be placed as a part of the manufacturing stages for creating the second MIM structure 640b. In embodiments, third spacer 629c may extend to cover edges of second metal layer 620b of MIM structure 640b, seeding layer 642a first metal layer 622a, and dielectric layer 624a. After the third spacer 629c is created, the second metal layer 620b may be applied to the dielectric layer 624a and over the third spacer 629c. As a result, the second metal layer 620b will be electrically isolated from first metal layer 622a. Note that at the time the third spacer 629c is manufactured, a fourth spacer 629d may also be concurrently manufactured.

With respect to stacked MIM structure 600, an area 630, which may be similar to area 330 of FIG. 3, may be referred to as an active area.

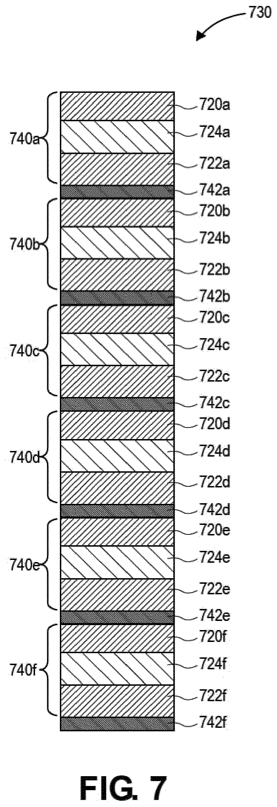

FIG. 7 illustrates an example of a multi-plate MIM structure, in accordance with various embodiments. MIM stack 730, which may be similar to MIM stack active portion 630 of FIG. 6, shows a stack of 6 MIMs 740a-740f, which may be similar to MIMs 640a, 640b of FIG. 6, that were manufactured based upon embodiments described herein and in particular with respect to FIGs. 5A-5D. In embodiments, the manufacturing stages may use one or more spacers (not shown), similar to spacers 649a-649d of FIG. 6, to create the MIM stack 730.

The first MIM 740a includes a second metal layer 720a, above a dielectric layer 724a that is placed on a first metal layer 722a that is on a seeding layer 742a. The second MIM 740b includes a second metal layer 720b, above a dielectric layer 724b that is placed on a first metal layer 722b that is on a seeding layer 742b. The third MIM 740c includes a second metal layer 720c, above a dielectric layer 724c that is placed on a first metal layer 722c that is on a seeding layer 742c. The fourth MIM 740d includes a second metal layer 720d, above a dielectric layer 724d that is placed on a first metal layer 722d that is on a seeding layer 742d. The fifth MIM 740e includes a second metal layer 720e, above a dielectric layer 724e that is placed on a first metal layer 722e that is on a seeding layer 742e. The sixth MIM 740f includes a second metal layer 720f, above a dielectric layer 724f that is placed on a first metal layer 722f that is on a seeding layer 742f. In other embodiments, there may be additional MIMs included in the MIM stack 730.

In embodiments, for each additional MIM included in the MIM stack 730, there is an increase in the charge density of the capacitance of the MIM stack 730. For example, starting with two MIMs 740a, 740b and adding a third MIM 740c will increase the gain 2 times. Adding a fourth MIM 740d will increase the gain an additional 1.5 times. Adding a fifth MIM 740e will increase the gain an additional 1.33 times. Adding a sixth MIM 740f will increase the gain an additional 1.25 times.

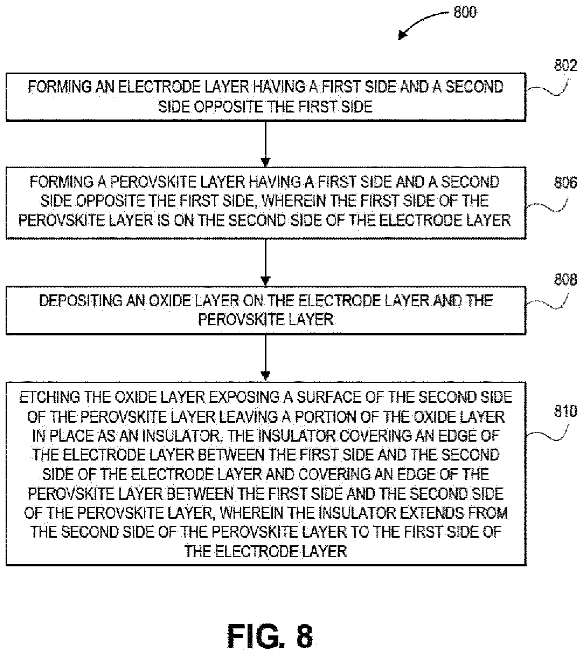

FIG. 8 illustrates an example process for manufacturing a multilayer MIM structure that includes edge insulators, in accordance with various embodiments. Process 800 may be implemented using examples and/or embodiments described herein, and in particular with respect to FIGs. 1A-7.

At block 802, the process may include forming an electrode layer having a first side and a second side opposite the first side.

At block 804, the process may further include forming a Perovskite layer having a first side and a second side opposite the first side, wherein the first side of the Perovskite layer is on the second side of the electrode layer.

At block 806, the process may further include depositing an oxide layer on the electrode layer and the Perovskite layer.

At block 810, the process may further include etching the oxide layer exposing a surface of the second side of the Perovskite layer leaving a portion of the oxide layer in place as an insulator, the insulator covering an edge of the electrode layer between the first side and the second side of the electrode layer and covering an edge of the Perovskite layer between the first side and the second side of the Perovskite layer, wherein the insulator extends from the second side of the Perovskite layer to the first side of the electrode layer.

Implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the spirit and scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or gate-all-around transistors such as nanoribbon and nanowire transistors. Although the implementations described herein may illustrate only Finfet transistors, it should be noted that the invention may also be carried out using planar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO2) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO₂), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

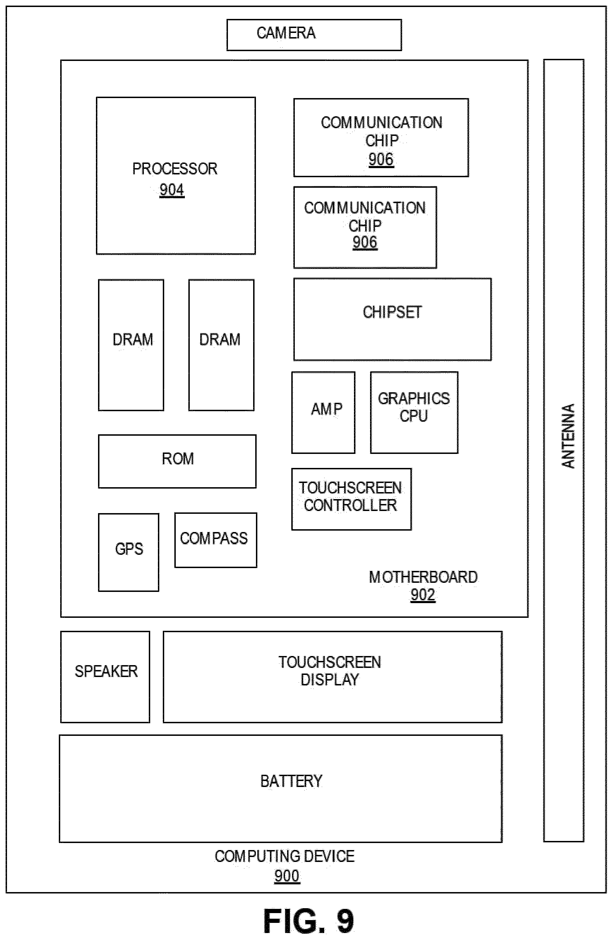

FIG. 9 illustrates a computing device 900 in accordance with one implementation of the invention. The computing device 900 houses a board 902. The board 902 may include a number of components, including but not limited to a processor 904 and at least one communication chip 906. The processor 904 is physically and electrically coupled to the board 902. In some implementations the at least one communication chip 906 is also physically and electrically coupled to the board 902. In further implementations, the communication chip 906 is part of the processor 904.

Depending on its applications, computing device 900 may include other components that may or may not be physically and electrically coupled to the board 902. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 906 enables wireless communications for the transfer of data to and from the computing device 900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 906 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 900 may include a plurality of communication chips 906. For instance, a first communication chip 906 may be dedicated to shorter range wireless communications such as Wi-Fi and Bluetooth and a second communication chip 906 may be dedicated to longer range wireless communications such as GPS, EDGE, GPRS, CDMA, WiMAX, LTE, Ev-DO, and others.

The processor 904 of the computing device 900 includes an integrated circuit die packaged within the processor 904. In some implementations of the invention, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 906 also includes an integrated circuit die packaged within the communication chip 906. In accordance with another implementation of the invention, the integrated circuit die of the communication chip includes one or more devices, such as MOS-FET transistors built in accordance with implementations of the invention.

In further implementations, another component housed within the computing device 900 may contain an integrated circuit die that includes one or more devices, such as MOS-FET transistors built in accordance with implementations of the invention.

In various implementations, the computing device 900 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 900 may be any other electronic device that processes data.

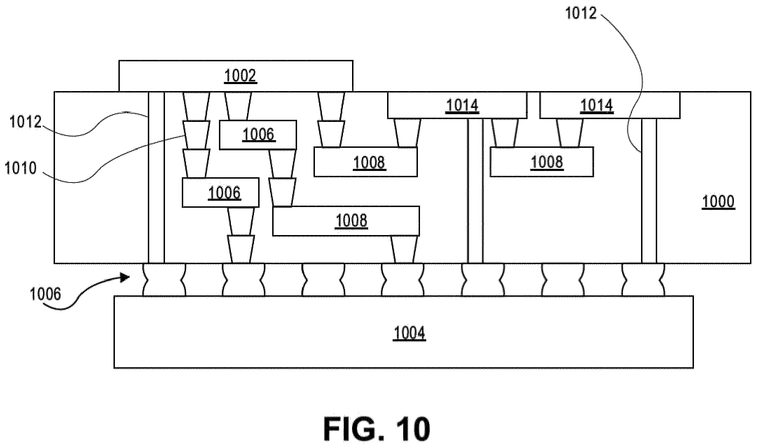

FIG. 10 illustrates an interposer 1000 that includes one or more embodiments of the invention. The interposer 1000 is an intervening substrate used to bridge a first substrate 1002 to a second substrate 1004. The first substrate 1002 may be, for instance, an integrated circuit die. The second substrate 1004 may be, for instance, a memory module, a computer motherboard, or another integrated circuit die. Generally, the purpose of an interposer 1000 is to spread a connection to a wider pitch or to reroute a connection to a different connection. For example, an interposer 1000 may couple an integrated circuit die to a ball grid array (BGA) 1006 that can subsequently be coupled to the second substrate 1004. In some embodiments, the first and second substrates 1002/1004 are attached to opposing sides of the interposer 1000. In other embodiments, the first and second substrates 1002/1004 are attached to the same side of the interposer 1000. And in further embodiments, three or more substrates are interconnected by way of the interposer 1000.

The interposer 1000 may be formed of an epoxy resin, a fiberglass-reinforced epoxy resin, a ceramic material, or a polymer material such as polyimide. In further implementations, the interposer 1000 may be formed of alternate rigid or flexible materials that may include the same materials described above for use in a semiconductor substrate, such as silicon, germanium, and other group III-V and group IV materials.

The interposer 1000 may include metal interconnects 1008 and vias 1010, including but not limited to through-silicon vias (TSVs) 1012. The interposer 1000 may further include embedded devices 1014, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 1000. In accordance with embodiments of the invention, apparatuses or processes disclosed herein may be used in the fabrication of interposer 1000.

The above description of illustrated embodiments, including what is described in the Abstract, is not intended to be exhaustive or to limit embodiments to the precise forms disclosed. While specific embodiments are described herein for illustrative purposes, various equivalent modifications are possible within the scope of the embodiments, as those skilled in the relevant art will recognize.

These modifications may be made to the embodiments in light of the above detailed description. The terms used in the following claims should not be construed to limit the embodiments to the specific implementations disclosed in the specification and the claims. Rather, the scope of the invention is to be determined entirely by the following claims, which are to be construed in accordance with established doctrines of claim interpretation.

The following paragraphs describe examples of various embodiments.

### EXAMPLES

1. A capacitor comprising: an electrode layer with a first side and a second side opposite the first side; a Perovskite layer with a first side and a second side opposite the first side, the first side of the Perovskite layer physically coupled with the second side of the electrode layer; and an insulator directly physically coupled with an edge of the electrode layer between the first side of the electrode layer and the second side of the electrode layer, and directly physically coupled with an edge of the Perovskite layer between the first side of the Perovskite layer and the second side of the Perovskite layer, wherein the insulator extends from the second side of the Perovskite layer to the first side of the electrode layer.

Example 2 includes the capacitor of example 1, wherein the insulator completely covers the edge of the electrode layer and the edge of the Perovskite layer.

Example 3 includes the capacitor of example 1, wherein a minimum thickness of the insulator in a direction parallel to the second side of the Perovskite layer is 20nm µm.

Example 4 includes the capacitor of example 1, further comprising; a seeding layer having a first side and a second side opposite the first side, the second side of the seeding layer directly physically coupled with the first side of the electrode layer; and wherein the insulator is directly physically coupled with an edge of the seeding layer between the first side of the seeding layer and the second side of the seeding layer, and wherein the insulator extends from the second side of the Perovskite layer to the first side of the seeding layer.

Example 5 includes the capacitor of example 4, wherein the electrode layer is a first electrode layer; and further comprising: a second electrode layer with a first side and a second side opposite the first side, the first side of the second electrode layer physically coupled with the second side of the Perovskite layer; and wherein the first electrode layer and the second electrode layer are electrically isolated from each other by the insulator.

Example 6 includes the capacitor of example 5, wherein the insulator is a first insulator, the seeding layer is a first seeding layer, and the Perovskite layer is a first Perovskite layer; and further comprising: a second seeding layer with a first side and a second side opposite the first side, the first side of the second seeding layer physically coupled with the second side of the second electrode layer; a third electrode layer with a first side and a second side opposite the first side, the first side of the third electrode layer physically coupled with the second side of the second seeding layer; a second Perovskite layer with the first side and a second side opposite the first side, the first side of the second Perovskite layer physically coupled with the second side of the third electrode layer; and a second insulator directly physically coupled with an edge of the second electrode layer between the first side of the second electrode layer and the second side of the second electrode layer, the second insulator directly physically coupled with an edge of the second seeding layer between the first side of the second seeding layer and the second side of the second seeding layer, the second insulator directly physically coupled with an edge of the third electrode layer between the first side of the third electrode layer and the second side of the third electrode layer, the second insulator directly physically coupled with an edge of the second Perovskite layer between the first side of the second Perovskite layer and the second side of the second Perovskite layer.

Example 7 includes the capacitor of example 6, wherein the second insulator extends from the second side of the second Perovskite layer to the first side of the second electrode layer.

Example 8 includes the capacitor of example 6, wherein the second insulator is directly physically coupled with the second side of the first Perovskite layer.

Example 9 includes the capacitor of example 6, wherein the first insulator and the second insulator are separate and distinct.

Example 10 includes the capacitor of example 6, further comprising: a fourth electrode layer with a first side and a second side opposite the first side, the first side of the second electrode layer physically coupled with the second side of the second Perovskite layer; and wherein the second insulator electrically isolates the fourth electrode layer and the third electrode layer from each other.

Example 11 includes the capacitor of example 10, wherein the fourth electrode layer and the first electrode layer are electrically coupled, wherein the third electrode layer and the second electrode layer are electrically coupled, wherein the first electrode layer and the second electrode layer are electrically isolated from each other by the first Perovskite layer, and wherein the third electrode layer and the fourth electrode layer are electrically isolated from each other by the second Perovskite layer.

Example 12 includes the capacitor of example 1, wherein the electrode layer and the Perovskite layer are substantially planar.

Example 13 includes the capacitor of example 1, wherein the insulator includes a selected one or more of: silicon, nitrogen, or oxygen.

Example 14 includes the capacitor of example 1, wherein the Perovskite layer includes a selected one or more of strontium, barium, titanium, oxygen, or lead.

Example 15 includes the capacitor of any one of examples 1-14, wherein a thickness of the electrode layer from the first side to the second side ranges from 5nm to 50nm.

Example 16 includes the capacitor of any one of examples 1-14, wherein a thickness of the Perovskite layer from the first side to the second side ranges from 5nm to 50nm.

Example 17 is a method comprising: forming an electrode layer having a first side and a second side opposite the first side; forming a Perovskite layer having a first side and a second side opposite the first side, wherein the first side of the Perovskite layer is on the second side of the electrode layer; depositing an oxide layer on the electrode layer and the Perovskite layer; and etching the oxide layer exposing a surface of the second side of the Perovskite layer leaving a portion of the oxide layer in place as an insulator, the insulator covering an edge of the electrode layer between the first side and the second side of the electrode layer and covering an edge of the Perovskite layer between the first side and the second side of the Perovskite layer, wherein the insulator extends from the second side of the Perovskite layer to the first side of the electrode layer.

Example 18 includes the method of example 17, wherein forming electrode layer further includes: depositing a seeding layer; and forming the first side of the electrode layer on the seeding layer.

Example 19 includes the method of example 17, wherein etching the oxide layer further includes etching the oxide layer using a dry etch.

Example 20 includes the method of example 17, wherein depositing the oxide layer further includes depositing the oxide layer using chemical vapor deposition (CVD).

Example 21 includes the method of any one of example 17-20, wherein the electrode layer is a first electrode layer; and further comprising: depositing a second electrode layer on the second side of the Perovskite layer, wherein the insulator electrically isolates the second electrode layer from the first electrode layer.

Example 22 is a package comprising: a substrate; a capacitor coupled with the substrate, the capacitor comprising: a first electrode layer with a first side and a second side opposite the first side, the first side of the first electrode layer coupled with the substrate; a Perovskite layer with a first side and a second side opposite the first side, the first side of the Perovskite layer physically coupled with the second side of the first electrode layer; an insulator directly physically coupled with an edge of the electrode layer between the first side of the first electrode layer and the second side of the electrode layer, and directly physically coupled with an edge of the Perovskite layer between the first side of the Perovskite layer and the second side of the Perovskite layer, wherein the insulator extends from the second side of the Perovskite layer to the first side of the first electrode layer; and a second electrode layer directly physically coupled with the second side of the Perovskite layer, the second electrode layer electrically isolated from the first electrode layer by the insulator.

Example 23 includes the package of example 22, wherein the insulator includes a selected one or more of: silicon, nitrogen, or oxygen.

Example 24 includes the package of example 22, wherein the first electrode, the second electrode, and the Perovskite layer are substantially planar.

Example 25 includes the package of example 22, wherein the first electrode and the second electrode include copper.

## Claims

1. A capacitor comprising:
an electrode layer with a first side and a second side opposite the first side;
a Perovskite layer with a first side and a second side opposite the first side, the first side of the Perovskite layer physically coupled with the second side of the electrode layer; and
an insulator directly physically coupled with an edge of the electrode layer between the first side of the electrode layer and the second side of the electrode layer, and directly physically coupled with an edge of the Perovskite layer between the first side of the Perovskite layer and the second side of the Perovskite layer, wherein the insulator extends from the second side of the Perovskite layer to the first side of the electrode layer.

2. The capacitor of claim 1, wherein the insulator completely covers the edge of the electrode layer and the edge of the Perovskite layer.

3. The capacitor of claim 1, wherein a minimum thickness of the insulator in a direction parallel to the second side of the Perovskite layer is 20nm µm.

4. The capacitor of claim 1, further comprising: a seeding layer having a first side and a second side opposite the first side, the second side of the seeding layer directly physically coupled with the first side of the electrode layer; and
wherein the insulator is directly physically coupled with an edge of the seeding layer between the first side of the seeding layer and the second side of the seeding layer, and wherein the insulator extends from the second side of the Perovskite layer to the first side of the seeding layer.

5. The capacitor of claim 4, wherein the electrode layer is a first electrode layer; and further comprising:
a second electrode layer with a first side and a second side opposite the first side, the first side of the second electrode layer physically coupled with the second side of the Perovskite layer; and
wherein the first electrode layer and the second electrode layer are electrically isolated from each other by the insulator.

6. The capacitor of claim 5, wherein the insulator is a first insulator, the seeding layer is a first seeding layer, and the Perovskite layer is a first Perovskite layer; and further comprising:
a second seeding layer with a first side and a second side opposite the first side, the first side of the second seeding layer physically coupled with the second side of the second electrode layer;
a third electrode layer with a first side and a second side opposite the first side, the first side of the third electrode layer physically coupled with the second side of the second seeding layer;
a second Perovskite layer with the first side and a second side opposite the first side, the first side of the second Perovskite layer physically coupled with the second side of the third electrode layer; and
a second insulator directly physically coupled with an edge of the second electrode layer between the first side of the second electrode layer and the second side of the second electrode layer, the second insulator directly physically coupled with an edge of the second seeding layer between the first side of the second seeding layer and the second side of the second seeding layer, the second insulator directly physically coupled with an edge of the third electrode layer between the first side of the third electrode layer and the second side of the third electrode layer, the second insulator directly physically coupled with an edge of the second Perovskite layer between the first side of the second Perovskite layer and the second side of the second Perovskite layer.

7. The capacitor of claim 6, wherein the second insulator extends from the second side of the second Perovskite layer to the first side of the second electrode layer.

8. The capacitor of claim 6, wherein the second insulator is directly physically coupled with the second side of the first Perovskite layer.

9. The capacitor of claim 6, wherein the first insulator and the second insulator are separate and distinct.

10. The capacitor of claim 6, further comprising:
a fourth electrode layer with a first side and a second side opposite the first side, the first side of the second electrode layer physically coupled with the second side of the second Perovskite layer; and
wherein the second insulator electrically isolates the fourth electrode layer and the third electrode layer from each other.

11. A method comprising:
forming an electrode layer having a first side and a second side opposite the first side;
forming a Perovskite layer having a first side and a second side opposite the first side, wherein the first side of the Perovskite layer is on the second side of the electrode layer;
depositing an oxide layer on the electrode layer and the Perovskite layer; and
etching the oxide layer exposing a surface of the second side of the Perovskite layer leaving a portion of the oxide layer in place as an insulator, the insulator covering an edge of the electrode layer between the first side and the second side of the electrode layer and covering an edge of the Perovskite layer between the first side and the second side of the Perovskite layer, wherein the insulator extends from the second side of the Perovskite layer to the first side of the electrode layer.

12. The method of claim 11, wherein forming electrode layer further includes:
depositing a seeding layer; and
forming the first side of the electrode layer on the seeding layer.

13. The method of claim 11, wherein etching the oxide layer further includes etching the oxide layer using a dry etch.

14. The method of claim 11, wherein depositing the oxide layer further includes depositing the oxide layer using chemical vapor deposition (CVD).

15. The method of claim 11, 12, 13 or 14, wherein the electrode layer is a first electrode layer; and further comprising:
depositing a second electrode layer on the second side of the Perovskite layer, wherein the insulator electrically isolates the second electrode layer from the first electrode layer.
